# EUROPÄISCHE PATENTSCHRIFT

(11) **EP 0 856 398 B1**
(45) Veröffentlichungstag und Bekanntmachung des Hinweises auf die Patenterteilung: **17.03.1999**
(21) Anmeldenummer: 96120030.0
(22) Anmeldetag: 13.12.1996
(51) Int. Cl.: B32B 15/01, C22C 11/06

(54) **Zinnplattiertes Bleiblech**
Lead sheet with tin cladding
Feuille de plomb revêtue d'étain

(43) Veröffentlichungstag der Anmeldung: 05.08.1998
(73) Patentinhaber: Verwaltungsgesellschaft Bleiindustrie GmbH & Co. KG vorm. Jung + Lindig, 22525 Hamburg (DE)
(72) Erfinder: Ernst, Johannes, D - 22339 Hamburg (DE); Heistermann, Lothar, D - 21335 Lüneburg (DE)
(74) Vertreter: Richter, Werdermann & Gerbaulet

(56) Entgegenhaltungen:
- DE-A- 2 737 023
- DE-A- 2 737 151
- DATABASE WPI Section Ch, Week 9014 Derwent Publications Ltd., London, GB; Class M26, AN 90-103658 XP002031483 & JP 02 054 734 A (NIPPON SEIHAKU KK) , 23.Februar 1990

## Beschreibung

Die Erfindung betrifft ein zinnplattiertes, bleihaltiges, platten- oder folienförmiges Grundmaterial aus zu Folien oder dünnen Platten strang- oder walzgepreßten, durch plastische Verformung innig miteinander verbundenen Blechen, Platten oder Folien.

Blei- und Kupferbleche sind besonders im Bauwesen viel verwandte Halbzeuge. So werden Bleibleche aufgrund ihrer leichten Verarbeitbarkeit für Abdeckungen vielerlei Art, wie z.B. Dach- und Ablaufeinfassungen, verwandt. Der guten Beständigkeit des Bleis gegen sehr viele Chemikalien steht aber seine Unbeständigkeit gegen frischen Mörtel entgegen, so daß Blei bei direkter Berührungsgefahr mit diesem stets einer besonders sorgfältigen Isolierung bedarf. Kupfer dagegen ist beständig gegen Alkalien und damit auch gegen Mörtel und Zement. Da außerdem die Oberfläche von Kupferblechen durch Witterungseinflüsse oxidiert und mit einer das ästhetische Gefühl ansprechenden Patina überzogen wird, werden Kupferbleche für komplette Dacheinfassungen verwandt. Der Nachteil der gegenüber Blei schwierigen Verarbeitbarkeit mußte dabei bisher hingenommen werden.

Es ist bekannt, um die Eigenschaften des Grundmetalls mit den Eigenschaften des Deckmetalls zu vereinigen, Verbundmetalle zu verwenden, was jedoch vorwiegend der Einsparung teurer NE-Metalle dient. Auch in der chemischen Industrie ist es bekannt, in jenen Fällen, bei denen die von Apparaten aus Bleiblech zu erreichende Festigkeit nicht ausreicht, die betreffenden Apparate aus einem den Festigkeitsanforderungen genügenden Grundwerkstoff herzustellen und danach mit Walzblei auszukleiden. Bei verzinnbaren Grundwerkstoffen erfolgt die Befestigung des Walzbleis durch Verlöten der einzelnen Stellen mit der Metallunterlage. Ferner sind zur Verbindung metallischer oder nichtmetallischer Werkstoffe Klebstoffe ebenso bekannt wie das Überziehen der miteinander zu verlötenden Gegenstände vor dem Verbinden mit Lötlegierungen.

Für ein Massenprodukt, wie z.B. Walzblei, welches auf Dächern und insbesondere bei der Herstellung von Dachfenstern verwendet wird, ist jedoch eine Auflage von 1% Zinn/Seite wegen des mehrfach höheren Zinn- als Bleipreises eine Verteuerung, die vom Markt nicht hingenommen wird. Eine Zinnauflage von 1% pro Blei/Seite führt zu einer kaum akzeptablen Kostenerhöhung.

Aus der DE-A-598 940 ist es bekannt, zur Herstellung von metallischen Formkörpern Platten, Bleche, Bänder, Folien oder Blätter gleicher oder unterschiedlicher Metallsorte zu Paketen oder Rollen zusammenzufügen und alsdann einer ggf. unter Anwendung von Hitze erfolgenden, eine innige Bindung der einzelnen Lagen miteinander auslösenden, plastischen Verformung zu unterwerfen. Um eine innige Bindung im Sinne einer Art Verschweißung mit dem Lagenmetall zu erreichen, sieht dieses Verfahren vor, daß zwischen die Metalllagen metallische oder nichtmetallische Stoffe, wie beispielsweise Grafit, eingebracht werden, die bei der plastischen Verformung zertrümmert werden und unter der Wirkung von Hitze und/oder Druck eine innige Bindung im Sinne einer Art Verschweißung mit dem Lagenmetall erfahren, wobei auch zwischen die metallischen Lagen pulverförmige Stoffe eingebracht werden können, die bei der plastischen Verformung mit dem Lagenmetall innig verbunden, also gewissermaßen verschweißt, werden. Auch das Einbringen von Flüssigkeiten oder Aufschwemmungen von festen Stoffen ggf. in Folienform zwischen die Metallagen ist bei diesem Verfahren vorgesehen. Diese Zwischenlagen hinterlassen beim Erhitzen feste Rückstände, die bei der plastischen Verformung eine innige Bindung nach Art der Verschweißung mit den Metallagen eingehen. Auch ohne Verwendung von Zwischenlagen aus metallischen oder nichtmetallischen, pulverförmigen oder flüssigen Stoffen, ggf. in Folienform, ist es möglich, innige Verbindungen der verschiedenen Metallagen dadurch zu erreichen, daß Metallfolien oder -bänder bzw. dünne Platten oder Bleche aus Ausgangsstoff paketiert oder zu Rollen zusammengewickelt werden, woraufhin dann anschließend diese Pakete oder Rollen in der Strang- oder Walzenpresse zu Folien oder dünnen Platten oder auch zu sonstigen Formkörpern umgewandelt werden, so daß es beispielsweise möglich ist, zahlreiche Aluminiumfolien vorgegebener Stärke aufeinanderzulegen und dieses Paket zu einer Folie von wiederum nur einer Stärke auszuwalzen, die der Stärke einer einzigen Aluminiumfolie entspricht.

Durch das ständige Verdrängen der Metallteilchen während des Walzprozesses tritt eine Metallverfestigung ein, so daß die einzelnen Metallagen eine innige Verbindung untereinander eingehen.

Dieses bekannte Verfahren befaßt sich jedoch nicht mit der Herstellung eines Massenproduktes unter Verwendung von Bleiblechen, welches auf Dächern und insbesondere bei der Herstellung von Dachfenstern verwendet wird, um eine kostensparende Bleiblechabdeckung zu erzielen, ohne daß dabei jedoch die Eigenschaften, wie Oberflächenbrillanz und gute Haftfestigkeit, beeinträchtigt werden.

Durch die DE-A-27 37 151 ist ein zinnplattiertes Bleiblech, aus zu Folien oder dünnen Platten strang- oder walzgepreßten, durch plastische Verformung innig miteinander verbundenen Blechen, Platten oder Folien aus unterschiedlichen Metallsorten und dessen Verwendung zur Herstellung von Rohrleitungen und Abdeckungen im Bauwesen, insbesondere für Dachabdeckungen und Dachfenstern, bekannt. Dieses zinnplattierte Bleiblech besteht aus einem ein- oder beidseitig mit einem Plattierungsprodukt aus einer einseitig mit einer Plattierung aus 0,5 bis 10 % Zinn oder hochzinnhaltigen Legierung versehenen und auf Plattierungsstärke herabgewalzten Bleiplatte Blei-auf-Bleiseite plattierten platten- oder folienförmigen Bleigrundmaterial. Mit einem derartigen zinnplattierten Bleiblech soll dem Blei eine verbesserte Oberfläche mit höherer Brillanz und besserer Haftfestigkeit gegeben werden, um es als Folien ausgewalzt besser bestreichen, bekleben, färben und verarbeiten zu können.

Bei der Herstellung von gefärbtem oder mit Kleber beschichtetem Walzblei ist eine vorhandene Zinnschicht in der Grenzfläche Blei/Substrat von entscheidender Bedeutung für die Langlebensdauereigenschaften hinsichtlich der Haltbarkeit der Lack- bzw. Kleberschicht. Das Fehlen einer Zinnschicht macht sich jedoch unter dem Einfluß von Luft und/oder Feuchtigkeit erst nach Wochen, ab etwa 12 Wochen, dahingehend bemerkbar, daß sich die Lack- oder Kleberschicht mechanisch leicht abheben läßt. Andererseits hat es sich auch gezeigt, daß dickere Bleibleche, ab 0,6 bis zu maximal üblichen Stärken von 3 mm (aus reinem Blei, Bleiinhalt > 99,9 %) bei starker mechanischer Verformung, z.B. Plissieren, zu einer Grobkornbildung neigen. Dies hat zur Folge, daß das verformte Blei an zahllosen Stellen in der Oberfläche entlang der Korngrenze des Bleis aufreißt. Auch hat es sich gezeigt, daß bei den bekannten zinnplattierten Bleiblechen bei starken Verformungen des Bleiblechs zwischenkristalline Brüche infolge Grobkornbildung auftreten mit der Folge, daß bei diesen zwischenkristallinen Brüchen die als primär benutzte, in der Regel sehr dünne Zinnschicht oder Zinnlegierung mit der Folge aufreißt, daß eine auf dieser Zinnschicht bzw. Zinnlegierung aufgebrachte Lack- oder Kleberschicht nicht homogen mit dem Grundmaterial Blei verbunden ist, so daß die Langlebensdauereigenschaften der Lack- bzw. der Kleberbindung auf der mit Zinn plattierten Bleiblechoberfläche sich verringern und es zu Abhebungen der Lack- bzw. der Kleberschicht kommt.

Es ist daher Aufgabe der vorliegenden Erfindung, ein zinnplattiertes Grundmaterial gemäß der eingangs beschriebenen Art mit einer Langlebensdauereigenschaft hinsichtlich der Haltbarkeit von auf das Bleiblech aufgebrachten Lack- oder Klebeschichten, zu schaffen, so daß bei einer Bleiblechverformung zwischenkristalline Brüche infolge Grobkornbildung vermieden werden, um ein Reißen der sehr dünnen Zinnschicht zu verhindern.

Gelöst wird diese Aufgabe bei einem zinnplattierten bleihaltigen, platten- oder folienförmigen Grundmaterial mit den in den Ansprüchen 1 und 2 angegebenen Merkmalen.

Es hat sich überraschenderweise gezeigt, daß bei der Verwendung eines bleihaltigen Grundmaterials aus einer wie folgt zusammengesetzten zinnhaltigen Legierung:
Sn: 0,15 bis 0,85 %
Sb: 0,05 bis 0,15 %
Cu: 0,03 bis 0,06 %
Bi: 0,01 bis 0,10 %
sonstige Beimengungen: max.: 0,10 %
Pb: Rest,
die sich sonst ergebenden Nachteile vermieden werden, so daß eine Langlebensdauereigenschaft hinsichtlich der Haltbarkeit der Lack- bzw. Kleberschicht auf dem zinnplattierten Bleiblech erhalten wird. Die Erfindung besteht somit im wesentlichen in dieser zinnhaltigen Legierung, die bei starken Verformungen ein zinnbeschichtetes Bleiblech daran hindert, zwischenkristalline Brüche infolge Grobkornbildung zu erleiden. Auch bei der Verwendung eines sehr dünnen Grundmaterials auf der Basis dieser Zinnlegierung haften die auf den Außenflächen aufgebrachten Lack- oder Kleberschichten, so daß unter dem Einfluß von Luft und/oder Feuchtigkeit kein Abheben der Lack- oder Kleberschicht erfolgt.

Die Erfindung sieht ferner als weitere Lösung der Aufgabe die Verwendung von zinnplattierten Bleiblechen mit den Merkmalen der Ansprüche 3 und 4 vor.

In der Zeichnung ist eine Ausführungsform des erfindungsgemäßen zinnplattierten Bleibleches dargestellt und zwar zeigt:
- Fig. 1: ein beidseitig mit einem aus Zinn und Blei bestehenden Plattierungsprodukt plattiertes bleihaltiges Grundmaterial aus einer Zinnlegierung mit auf dem Plattierungsprodukt außenseitig aufgebrachter Schicht eines Lackes oder eines Klebers in einem senkrechten Schnitt und
- Fig. 2: das Plattierungsprodukt in einem senkrechten Schnitt.

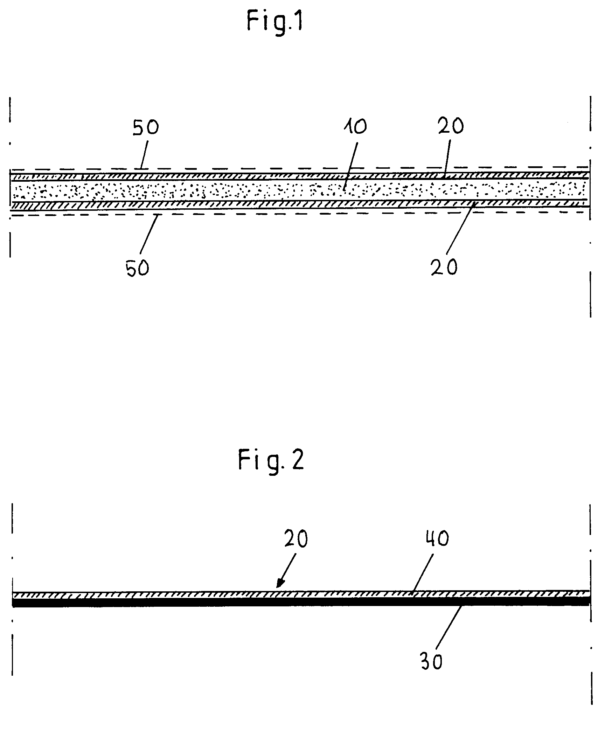

In den Fig. 1 und 2 ist der Grundaufbau eines ein- oder beidseitig zinnplattierten bleihaltigen Grundmaterials dargestellt, bei dem ein platten- oder folienförmiges Grundmaterial 10 ein- oder beidseitig mit einer Plattierungsschicht 20 verbunden ist.

Das der Schicht 20 zugrundeliegende Plattierungsprodukt, das aus einer Bleiplatte 30 besteht, auf die einseitig eine Beschichtung 40 aus Zinn oder einer Zinnlegierung aufplattiert ist, so daß letztlich Zinn und Blei mechanisch miteinander verschweißt sind. Ein derart hergestelltes Plattierungsprodukt wird auf Plattierungsstärke herabgewalzt und die so gewonnene Plattierungsschicht ein- oder beidseitig auf das Grundmaterial 10 so aufplattiert, daß die Bleischicht des Plattierungsproduktes 20 auf dem Grundmaterial 10 zu liegen kommt. Das Grundmaterial 10, also quasi das Bleigrundmaterial, auf das das Plattierungsprodukt 20 aufplattiert ist, besteht aus einer zinnhaltigen Legierung, die sich wie folgt zusammensetzt:
Sn: 0,15 bis 0,85 %
Sb: 0,05 bis 0,15 %
Cu: 0,03 bis 0,06 %
Bi: 0,01 bis 0,10 %
sonstige Beimengungen: max.: 0,10 %
Pb: Rest.

Sowohl bei der Plattierungsschicht 20 als auch bei dem Grundmaterial 10 handelt es sich um eine sehr dünne schichten.

Auf die Plattierungsschicht 20 ist außenseitig eine Beschichtung 50 aus einem Lack oder einem Klebemittel aufgebracht (Fig. 1).

Die Prozentangaben beziehen sich auf Gewichtsprozent, bezogen auf das Gesamtgewicht.

## Patentansprüche

1. Zinnplattiertes bleihaltiges, platten- oder folienförmiges Grundmaterial aus zu Folien oder dünnen Platten strang- oder walzgepreßten, durch plastische Verformung innig miteinander verbundenen Blechen, Platten oder Folien,
dadurch gekennzeichnet,
daß zur Verhinderung zwischenkristalliner Brüche bei einer Bleiblechverformung das Bleigrundmaterial (10) mit der ein- oder beidseitig aufgebrachten Zinnplattierungsschicht aus einer zinnhaltigen Legierung folgender Zusammensetzung besteht:
Sn: 0,15 bis 0,85 %
Sb: 0,05 bis 0,15 %
Cu: 0,03 bis 0,06 %
Bi: 0,01 bis 0,10 %
sonstige Beimengungen: max.: 0,10 %
Pb: Rest,
wobei die Außenseite der Zinnplattierungsschicht mit einer Lack- oder Kleberschicht (50) versehen ist.

2. Zinnplattiertes bleihaltiges, platten- oder folienförmiges Grundmaterial aus zu Folien oder dünnen Platten strang- oder walzgepreßten, durch plastische Verformung innig miteinander verbundenen Blechen, Platten oder Folien,
dadurch gekennzeichnet,
daß das Bleigrundmaterial ein- oder beidseitig mit einem Plattierungsprodukt aus einer einseitig mit einer Plattierung (40) aus Zinn oder einer Zinnlegierung versehenen und mit einer auf Plattierungsstärke herabgewalzten Bleiplatte (30) versehen ist, wobei das Plattierungsprodukt mit seiner Bleiseite auf das Bleigrundmaterial (10) aufplattiert ist, das zur Verhinderung zwiischenkristalliner Brüche bei einer Bleiblechverformung aus einer zinnhaltigen Legierung mit folgender Zusammensetzung besteht:
Sn: 0,15 bis 0,85 %
Sb: 0,05 bis 0,15 %
Cu: 0,03 bis 0,06 %
Bi: 0,01 bis 0,10 %
sonstige Beimengungen: max.: 0,10 %
Pb: Rest,
wobei auf der Außenfläche des Plattierungsproduktes eine Lack- oder Kleberschicht (50) aufgebracht ist.

3. Verwendung eines zinnplattierten bleihaltigen, platten- oder folienförmigen Grundmaterials mit ein- oder beidseitig auf das Bleigrundmaterial (10) aufgebrachten Zinnplattierungsschicht (40) aus Zinn oder einer Zinnlegierung, wobei das Bleigrundmaterial aus einer zinnhaltigen Legierung mit folgender Zusammensetzung besteht:
Sn: 0,15 bis 0,85 %
Sb: 0,05 bis 0,15 %
Cu: 0,03 bis 0,06 %
Bi: 0,01 bis 0,10 %
sonstige Beimengungen: max.: 0,10 %
Pb: Rest,
und wobei auf die Außenfläche der Zinnplattierungsschicht (40) eine Lack- oder Kleberschicht (50) aufgebracht ist, zur Verhinderung zwischenkristalliner Brüche bei einer Bleiblechverformung und zur Erhöhung der Haftfähigkeit von außenseitig auf das Bleiblech aufgebrachter Lack- oder Kleberschicht.

4. Verwendung eines zinnplattierten bleihaltigen platten- oder folienförmigen Grundmaterials (10) aus einer zinnhaltigen Legierung aus
Sn: 0,15 bis 0,85 %
Sb: 0,05 bis 0,15 %
Cu: 0,03 bis 0,06 %
Bi: 0,01 bis 0,10 %
sonstige Beimengungen: max.: 0,10 %
Pb: Rest,
mit einer ein- oder beidseitig auf das Grundmaterial bleischichtseitig aufplattierten Plattierungsschicht (20) aus einer auf Plattierungsstärke herabgewalzten Bleiplatte (30) mit einer einseitig aufgebrachten Schicht (40) aus Zinn oder einer Zinnlegierung, wobei auf die Außenfläche des Plattierungsproduktes eine Lack- oder Kleberschicht aufgebracht ist, zur Verhinderung zwischenkristalliner Brüche bei einer Bleiblechverformung und zur Erhöhung dar Haftfähigkeit von außenseitig auf das Bleiblech aufgebrachter Lack- oder Kleberschicht.

## Claims

1. Tin-clad, plumbiferous, plate or foil-like base material of sheets, plates or foils extruded or rolled so as to form foils or thin plates which are intimately bonded to each other by means of platic deformation,
**characterized in that,**
for the prevention of intercrystalline cracks in a lead sheet deformation, the lead base material (10) with the layer of tin cladding applied to one or both sides is comprised of a stanniferous alloy possessing the following composition:
Sn: 0.15 to 0.85%
Sb: 0.05 to 0.15%
Cu: 0.03 to 0.06%
Bi: 0.01 to 0.10%
other admixtures: maximally: 0.10%
Pb: the remainder,
while the outside of the tin cladding layer is provided with a coating of varnish or adhesive (50).

2. Tin-clad, plumbiferous, plate or foil-like base material of sheets, plates or foils extruded or rolled so as to form foils or thin plates which are intimately bonded to each other by means of plastic deformation,
**characterized in that**
the lead base material is provided on one or both sides with a cladding product of a lead plate (30) provided on one side with a cladding (40) of tin or a tin alloy which has been reduced by rolling to cladding thickness, while the cladding product, with its lead side, is clad onto the lead base material (10), which, for the prevention of intercrystalline cracks in a lead sheet deformation, is comprised of a stanniferous alloy possessing the following composition:
Sn: 0.15 to 0.85%
Sb: 0.05 to 0.15%
Cu: 0.03 to 0.06%
Bi 0.01 to 0.10%
other admixtures: maximally 0.10%
Pb: the remainder,
while the outside of the cladding product is provided with a varnish or adhesive coating (50).

3. Utilization of a tin-clad, plumbiferous plate or foil-like base material with a tin cladding layer (40) applied to one or both sides to the lead base material (10) of tin or a tin alloy, wherein the lead base material is composed of a stanniferous alloy possessing the following composition:
Sn: 0.15 to 0.85%
Sb: 0.05 to 0.15%
Cu: 0.03 to 0.06%
Bi: 0.01 to 0.10%
other admixtures: maximally 0.10%
Pb: the remainder,
and wherein, onto the external surface area of the tin cladding layer (40), a varnish or adhesive layer (50) is applied for the prevention of intercrystalline cracks in a lead sheet deformation and for increasing the adhesive property of the varnish or adhesive coating applied externally to the lead sheet.

4. Utilization of a tin-clad, plumbiferous plate or foil-like base material (10) of a stanniferous alloy comprised of:
Sn: 0.15 to 0.85%
Sb: 0.05 to 0.15%
Cu: 0.03 to 0.06%
Bi 0.01 to 0.10%
other admixtures: maximally 0.10%
Pb: the remainder,
with a cladding layer (20) clad onto one or both sides on the lead layer side of lead sheet (30) reduced by rolling to cladding thickness with a unilaterlly applied layer (40) of tin or a stanniferous alloy, while, onto the external surface area of the cladding product, a varnish or adhesive coating is applied in order to prevent intercrystalline cracks in a lead sheet deformation and so as to increase the adhesive property of the varnish or adhesive coating applied externally to the lead sheet.

## Revendications

1. Matériau de base à base de plomb revêtu d'étain en forme de plaque ou de feuille composé de plaques extrudées ou pressées au rouleau en feuilles ou en plaques minces, reliées intimement les unes aux autres par déformation plastique,
caractérisé en ce
que, pour éviter des ruptures cristallines intermédiaires lors d'une déformation de la plaque de plomb, le matériau de base à base de plomb (10) avec la couche de placage d'étain appliquée sur un côté ou des deux côtés est constitué par un alliage à base d'étain de la composition suivante :
Sn : 0,15 à 0,85 %
Sb : 0,05 à 0,15 %
Cu : 0,03 à 0,06 %
Bi : 0,01 à 0,10 %
Autres additifs : 0,10 % maxi.
Pb : reste
le côté extérieur de la couche de placage d'étain étant pourvu d'une couche de laque ou de colle (50).

2. Matériau de base à base de plomb revêtu d'étain en forme de plaque ou de feuille composé de plaques extrudées ou pressées au rouleau en feuilles ou en plaques minces, reliées intimement les unes aux autres par déformation plastique,
caractérisé en ce
que le matériau de base à base de plomb est revêtu d'un côté ou des deux côtés par un produit de placage constitué par une plaque de plomb (30) revêtue d'un côté par un placage (40) en étain ou en un alliage en étain et réduite au rouleau à l'épaisseur du placage, le matériau du placage étant plaqué avec sa face de plomb sur le matériau de base à base de plomb (10) qui, pour éviter des ruptures cristallines intermédiaires lors d'une déformation de la plaque de plomb, est constitué par un alliage à base d'étain de la composition suivante :
Sn : 0,15 à 0,85 %
Sb : 0,05 à 0,15 %
Cu : 0,03 à 0,06 %
Bi : 0,01 à 0,10 %
Autres additifs : 0,10 % maxi.
Pb : reste
une couche de laque ou de colle (50) étant appliquée sur la face extérieure du produit de placage.

3. Utilisation d'un matériau de base à base de plomb revêtu d'étain, en forme de plaque ou de feuille, avec une couche de placage d'étain (40) en étain ou en un alliage d'étain appliquée d'un côté ou des deux côtés sur le matériau de base à base de plomb (10), le matériau de base à base de plomb étant constitué par un alliage à base d'étain de la composition suivante :
Sn : 0,15 à 0,85 %
Sb : 0,05 à 0,15 %
Cu : 0,03 à 0,06 %
Bi : 0,01 à 0,10 %
Autres additifs : 0,10 % maxi.
Pb : reste,
et une couche de laque ou de colle (50) étant appliquée sur la surface extérieure de la couche de placage d'étain (40) pour éviter des ruptures cristallines intermédiaires lors d'une déformation de plaque de plomb et pour augmenter l'aptitude à l'adhérence de la couche de laque ou de colle appliquée sur le côté extérieur sur la plaque de plomb.

4. Utilisation d'un matériau de base à base de plomb plaqué d'étain en forme de plaque ou de feuille (10) composé d'un alliage à base d'étain composé de
Sn : 0,15 à 0,85 %
Sb : 0,05 à 0,15 %
Cu : 0,03 à 0,06 %
Bi : 0,01 à 0,10 %
Autres additifs : 0,10 % maxi.
Pb : reste,
avec une couche de placage (20) plaquée d'un côté ou des deux côtés sur le matériau de base du côté de la couche de plomb, constituée par une plaque de plomb (30) réduite au rouleau à l'épaisseur du placage avec une couche (40) en étain ou en un alliage d'étain appliquée sur un côté, une couche de laque ou de colle étant appliquée sur la face extérieure du produit de placage pour éviter des ruptures cristallines intermédiaires lors d'une déformation de la plaque de plomb et pour augmenter l'aptitude à l'adhérence de la couche de laque ou de colle appliquée sur le côté extérieur sur la plaque de plomb.
